# EUROPEAN PATENT SPECIFICATION

(11) **EP 2 645 404 B1**
(45) Date of publication and mention of the grant of the patent: **07.06.2023**
(21) Application number: 11843776.3
(22) Date of filing: 25.11.2011
(51) Int. Cl.: H01L 21/027, G02B 27/48, G02B 26/10, G02B 19/00, G03F 7/20, G02B 26/08

(54) **EXPOSURE APPARATUS**
BELICHTUNGSGERÄT
APPAREIL D'EXPOSITION

(30) Priority: 26.11.2010 JP 2010263906
(43) Date of publication of application: 02.10.2013
(73) Proprietor: Dai Nippon Printing Co., Ltd., Tokyo 162-8001 (JP)
(72) Inventor: ISHIDA Kazutoshi, Tokyo 162-8001 (JP); KURASHIGE Makio, Tokyo 162-8001 (JP); TAKANOKURA Tomoe, Tokyo 162-8001 (JP); OOYAGI Yasuyuki, Tokyo 162-8001 (JP)
(74) Representative: Müller-Boré & Partner Patentanwälte PartG mbB
(86) International application number: PCT/JP2011/077216
(87) International publication number: WO 2012/070651

(56) References cited:
- EP-A1- 1 976 303
- EP-A1- 2 128 694
- JP-A- 1 220 825
- JP-A- 7 142 354
- JP-A- 9 006 011
- JP-A- 2000 277 421
- JP-A- 2008 085 266
- JP-A- 2010 197 916
- US-A1- 2010 045 894
- US-B2- 7 643 194

## Description

### Technical Field

The present invention relates to an exposure apparatus that guides coherent light beams to the surface of an exposure medium.

### BACKGROUND ART

Exposure apparatuses, for example, photolithography used for pattern formation for semiconductor devices have adopted a technique of transferring a reticle (mask) pattern onto a substrate such as a semiconductor wafer. In this technique, a photosensitive photoresist is applied on a substrate, a reticle is placed on the photoresist, and a high pressure mercury lamp, a metal halide lamp, etc. is provided above the reticle to illuminate the reticle, thereby a radiated light image corresponding to the reticle (mask) pattern being formed on the photoresist.

Generally, in projection exposure apparatuses for example a stepper, a pattern to be transferred drawn on a reticle is projected onto a substrate via a projection optical module and formed thereon.

However, high intensity discharge lamps such as high pressure mercury lamps have a relatively short lifecycle and need to be frequently replaced. In addition, since these lamps are a diffusion light source with a plurality of wavelengths, it is required to use a relatively large and highly functional optical module for light convergence, reshaping and image formation, there is a problem in that the entire system becomes larger.

In order to cope with such problems, a system using a coherent light source such as a laser has also been proposed. For example, semiconductor lasers which have been widely used in industries have a very long lifecycle in comparison with high intensity discharge lamps such as high pressure mercury lamps. In addition, since semiconductor lasers are capable of generating light of high straightness and a single wavelength, an optical module can be compact and simple, so that there is an advantage in that the entire system becomes smaller and light utilization efficiency is improved.

On the other hand, in the unit using a coherent light source of laser beams or the like, there is another problem in that speckles are generated. Speckles are a spotted pattern which is formed when a coherent light beam such as a laser beam is emitted to a scattering plane. If speckles are generated on a screen, they are observed as spotted luminance unevenness, i.e. brightness unevenness, thus becoming a factor of having physiologically adverse affect on an observer. It is considered that the reason why speckles are generated in the case of using coherent light beams is that coherent light beams reflected from respective portions of a scattering and reflecting plane such as a screen have very high coherency so that coherent light beams interfere with one another to generate speckles. For example, a theoretical review of the generation of speckles is made in detail in Speckle Phenomena in Optics, Joseph W. Goodman, Roberts & Co., 2006.

As discussed above, in the unit using a coherent light source, since there is a problem of generation of speckles unique to the coherent light source, techniques for suppressing the generation of speckles have been proposed. For example, Japanese Patent Laid-Open No. 6-208089 discloses a technique in which a laser beam is emitted to a scattering plate, scattered light beams obtained therefrom are guided to a spatial light modulator, and the scattering plate is driven to rotate by a motor, thus reducing speckles.

EP 2 128 694 A1 describes a laser illuminating device and an image display device that enable to remove speckle noises in a diffraction field and an image field, and uniformly illuminate an illumination plane. The laser illuminating device includes a laser light source, a first lens including a plurality of microlenses each having a predetermined numerical aperture in an in-plane direction, each of the microlenses being adapted to expand laser light emitted from the laser light source to thereby superimpose the laser light transmitted through each of the microlenses; and a second lens having an effective diameter larger than an effective diameter of the first lens, and for compensating for a divergence angle of the laser light expanded by each of the plurality of the microlenses.

EP 1 976 303 A1 describes an image generating apparatus which comprises a plurality of image generating optical paths and single and common means for simultaneously deflecting a received plurality of light beams of primary illumination light having coherence properties. Said light beams are assigned to said respective optical paths. Said single common means for deflecting is configured in order to simultaneously optically couple each of said received light beams into a respective assigned optical path and in order to irradiate intermediate faces of illumination units of each respective optical path with said respective assigned light beam as well as an order to have - during said process of irradiating - each of said beams subsequently in time irradiate different portions of said respective assigned intermediate faces.

US 2010/045894 A1 describes a planar illumination apparatus for use by a liquid crystal display apparatus. The planar illumination apparatus comprises a laser light source operable to emit laser lights having equally oriented polarization planes, a one-dimensional diffuser operable to diffuse the laser lights emitted from the laser light source at an angle in a one-dimensional direction, a cylindrical lens section operable to convert, to parallel lights, the laser lights diffused by the one-dimensional diffuser, and a light guide plate, having a rectangular parallelepiped shape having two main surfaces and four side surfaces, operable to receive the laser lights which are the parallel lights obtained through conversion performed by the cylindrical lens section, on one of the four side surfaces such that the one-dimensional direction is parallel to the two main surfaces, and operable to emit the laser lights from one of the two main surfaces.

### DISCLOSURE OF INVENTION

Conventionally, several techniques for reducing speckles have been proposed, however, the techniques proposed so far cannot effectively and sufficiently suppress the generation of speckles. For example, according to the method disclosed in Japanese Patent Laid-Open No. 6-208089 described above, laser beams irradiated to a scattering plate are scattered. Therefore, part of the laser beams is inevitably lost with no contribution to image display. In addition, a scattering plate needs to be rotated in order to reduce speckles. However, such a mechanical rotation mechanism becomes a relatively large apparatus, and power consumption is increased. Moreover, even if the scattering plate is rotated, the position of the optical axis of an illumination light beam is not changed, hence it is impossible to sufficiently suppress the generation of speckles caused by the diffusion on a screen.

Moreover, speckles are not a problem unique to projection apparatuses but a problem to various apparatuses having an illumination device incorporated therein for illuminating an illumination zone with coherent light beams. For example, scanners for reading image information have an illumination device incorporated therein for illuminating an object to be read. When speckles are generated due to light that illuminates an object to be read, it is impossible to read image information accurately. In order to avoid such inconvenience, scanners utilizing coherent light beams are required to perform a special process such as image correction.

Coherent light beams, for example laser beams as a typical example, have excellent straightness and can be emitted as a light of extremely high energy density. Therefore, it is preferable for illumination devices actually developed to design the optical path of coherent light beams in accordance with the characteristics of coherent light beams.

The inventors have extensively researched under consideration of the points discussed above, and as a result, the inventors have contrived the invention regarding an exposure apparatus which illuminates a region repeatedly with coherent light beams that are diffracted by a hologram recording medium or the like and guides the illumination light to an exposure medium, to make speckles inconspicuous on the exposure medium. Moreover, the inventors have proceeded with researches and succeeded in improvement in the exposure apparatus to constantly prevent the generation of a region extremely bright in the region illuminated with coherent light beams which have been diffracted by a hologram recording medium and superimposed on one another on the region. Namely, the purpose of the present invention is to provide an exposure apparatus capable of making speckles inconspicuous on an optical image formed on an exposure medium and effectively suppressing the generation of brightness unevenness in a region illuminated with coherent light beams which have been diffracted by a hologram recording medium and superimposed on one another on the region.

In order to solve the problems above, according to an aspect of the present invention, there are provided an exposure apparatus as defined in claim 1 and a use of an exposure apparatus as defined in claim 12. Further preferred embodiments are set forth in the dependent claims.

According to the present invention, it is possible to make speckles inconspicuous effectively in a zone provided overlapping with a light modulator and on the surface of a photosensitive medium and also restrict brightness unevenness in the zone provided overlapping with the light modulator and on the surface of the photosensitive medium.

### BRIEF DESCRIPTION OF DRAWINGS

FIG. 1 is a view showing a schematic configuration of an exposure apparatus according to a basic embodiment of the present invention;
FIG. 2 is a view explaining an operational principle of an illumination device 40 of FIG. 1;
FIG. 3 is a view explaining a state in which an image of a scattering plate is generated on a hologram recording medium 55 as interference fringes;
FIG. 4 is a view explaining a state in which an image of a scattering plate is reproduced using interference fringes formed in the hologram recording medium 55 obtained through an exposure process of FIG. 3;
FIG. 5 is a view explaining a scanning route of a scanning device 65;
FIG. 6 is a view showing a schematic configuration of an exposure apparatus according to an applied embodiment of the present invention;
FIG. 7 is a view showing results of measuring speckle contrasts in the cases where the hologram recording medium 55 was used and not used;
FIG. 8 is a view showing a schematic configuration of an exposure apparatus according to a second embodiment of the present invention;
FIG. 9 is a view showing an example of a scanning device rotatable in two axes directions;
FIG. 10 is a view showing an example of making a parallel beam incident on the hologram recording medium 55; and
FIG. 11 is a view showing a schematic configuration of an irradiation unit 60 using a lens array according to a third embodiment.

### BEST MODE FOR CARRYING OUT THE INVENTION

Hereinafter, embodiments of the present invention will be explained with reference to the drawings. In the accompanying drawings of the present description, in order for simplifying drawings and easy understanding, the scale, the ratio of height to width, etc., are appropriately modified or enlarged.

### [First Embodiment]

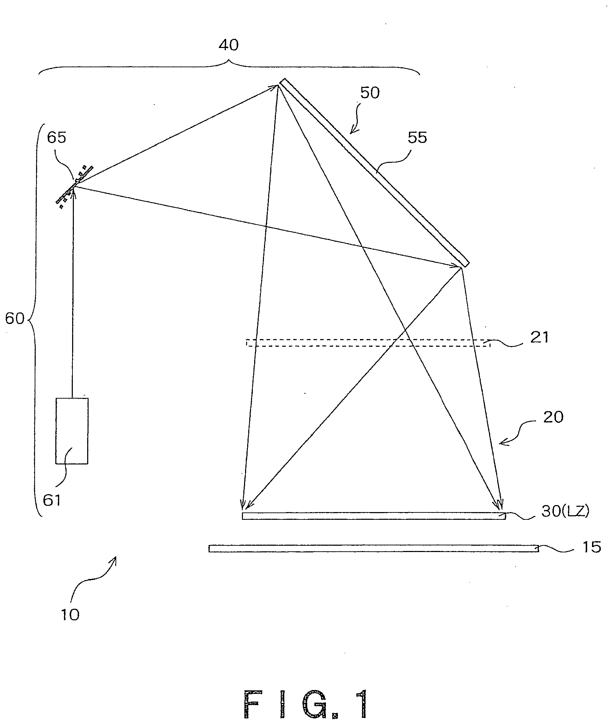

An exposure apparatus according to a first embodiment of the present invention is capable of effectively preventing speckle, as a basic embodiment. Moreover, an exposure apparatus according to an applied embodiment of the present invention features an image forming module in addition to the configuration of the basic embodiment. Firstly, the basic embodiment of the present invention will be explained with reference to FIGS. 1 to 5.

### [Configuration of Basic Embodiment]

FIG. 1 is a view showing a schematic configuration of an exposure apparatus according to the basic embodiment of the present invention. An exposure apparatus 10 shown in FIG. 1 is provided with an optical device 50, an irradiation unit 60, and a spatial light modulator 30. Coherent light beams modulated by the spatial light modulator 30 are guided to the surface of the exposure medium 15. The optical device 50 and the irradiation unit 60 are included in an illumination device 40.

The optical device 50 has a hologram recording medium 55 that can reproduce an image of a scattering plate in an illumination zone (a specific zone) LZ. The details of the hologram recording medium 55 will be explained later.

The irradiation unit 60 irradiates the optical device 50 with coherent light beams so that the coherent light beams scan the surface of the optical device 50. The irradiation unit 60 has a laser source 61 that emits coherent light beams and a scanning device 65 that scans the surface of the optical device 50 with the coherent light beams emitted from the laser source 61.

The spatial light modulator 30 is, for example, a reticle (mask) of transmission-type or reflection-type. In this case, an optical image corresponding to a reticle pattern is formed on the surface of the exposure medium 15, which can be used as an exposure apparatus for fabricating a semiconductor device.

Or the spatial light modulator 30 may be a transmission-type liquid crystal microdisplay. In this case, the spatial light modulator 30 is illuminated by the illumination device 40 in the plane direction and coherent light beams pass through the spatial light modulator 30 selectively per pixel. In this way, a modulated image (an optical image) of a fine pattern can be formed on the exposure medium 15.

Moreover, it is preferable that the incidence plane of the spatial light modulator 30 has the same shape and size as the illumination zone LZ that is illuminated with coherent light beams by the illumination device 40. In this case, coherent light beams from the illumination device 40 can be used for exposure of the exposure medium 15 at high efficiency.

The exposure medium 15 is, for example, a semiconductor wafer applied with a resist pattern. However, there is no limitation on the type of the exposure medium 15. The exposure medium 15 may be a film applied with a photosensitizer.

The exposure medium 15 is provided as close as possible to the spatial light modulator 30. Hereinbelow, the reason will be explained in detail. If the spatial light modulator 30 is, for example, a mask, and when coherent light beams are incident on an edge of the mask, the coherent light beams are diffracted at this edge, thereby a diffracted image is obtained. The effect of the diffracted image becomes larger as the gap between the spatial light modulator 30 and the exposure medium 15 becomes larger, so that an optical image originally from the mask becomes blurry. Therefore, in this basic embodiment, in order to reduce the effect of a diffracted image, the exposure medium 15 is provided as close as possible to the spatial light modulator 30.

As explained above, since the exposure medium 15 has to be provided as close as possible to the spatial light modulator 30, the spatial light modulator 30 is limited to a transmission-type element, such as a reticle or liquid crystal microdisplay, a reflection-type element being difficult to be installed.

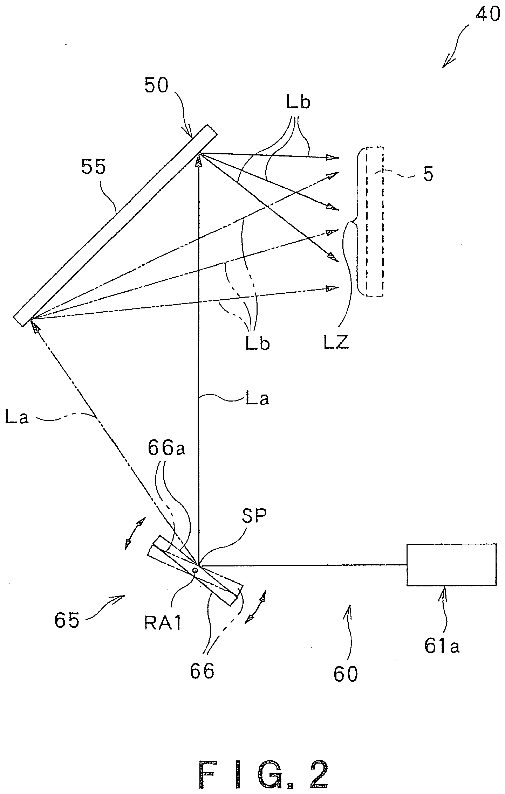

FIG. 2 is a view explaining an operational principle of the illumination device 40 of FIG. 1. In FIG. 2, in order for easy explanation, only some components of the illumination device 40 are shown. Hereinafter, the basic operational principle of the illumination device 40 of FIG. 1 will be explained using FIG. 2.

The hologram recording medium 55 of the optical device 50 can receive coherent light beams emitted from the irradiation unit 60 as reproduction illumination light beams La and diffract the coherent light beams at high efficiency. Above all, the hologram recording medium 55 is configured to be capable of reproducing an image 5 of a scattering plate 6 in the illumination zone LZ by diffracting coherent light beams incident on its respective positions, in other words, respective micro zones which should be called respective points.

The irradiation unit 60 is configured so that the scanning device 65 uses coherent light beams emitted to the hologram recording medium 55 to scan the hologram recording medium 55. Therefore, at a moment, the irradiation unit 60 irradiates a micro zone on the surface of the hologram recording medium 55 with a coherent light beam.

Coherent light beams emitted from the irradiation unit 60 to scan the hologram recording medium 55 are incident on respective positions, i.e. respective points or respective zones on the hologram recording medium 55 at an incident angle that satisfies diffraction conditions of the hologram recording medium 55. Coherent light beams incident on respective positions of the hologram recording medium 55 from the irradiation unit 60 are diffracted by the hologram recording medium 55 to illuminate the specific zones that are overlapped with one another at least partially. Above all in the embodiment described here, coherent light beams incident on respective positions of the hologram recording medium 55 from the irradiation unit 60 are diffracted by the hologram recording medium 55 to illuminate the same illumination zone LZ. In more detail, as shown in FIG.2, the coherent light beams incident on respective positions of the hologram recording medium 55 from the irradiation unit 60 reproduce the image 5 of the scattering plate 6 in a manner that the image 5 is superimposed on the illumination zone LZ. Namely, each coherent light beam incident on each position of the hologram recording medium 55 from the irradiation unit 60 is diffused, i.e. spread by the optical device 50 to be incident on the illumination zone LZ.

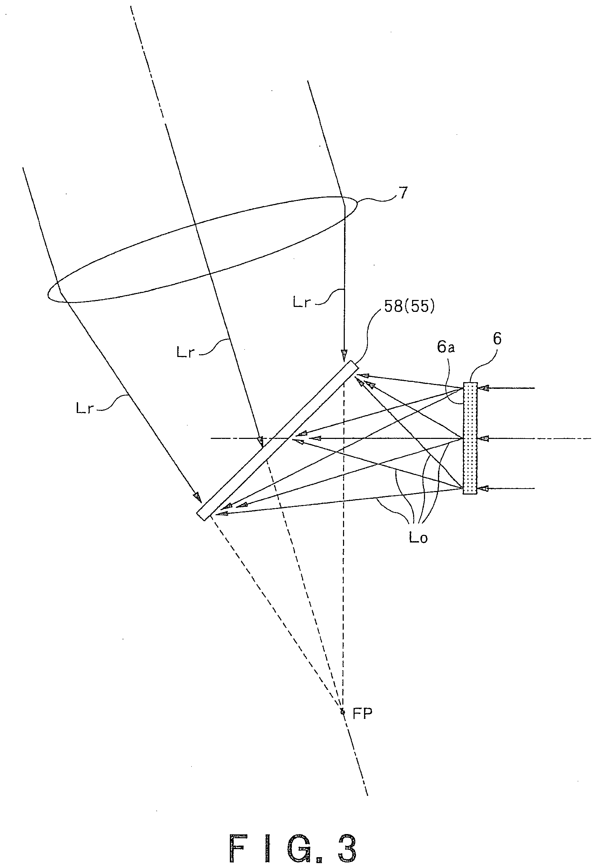

As for the hologram recording medium 55 that enables the diffraction of coherent light beams described above, in the example shown, a reflection-type volume hologram using photopolymer is used. FIG. 3 is a view explaining a state in which an image of a scattering plate is generated on the hologram recording medium 55 as interference fringes. Here, the scattering plate 6 is a reference member for scattering light and it does not matter what a configuration the scattering plate 6 has.

As shown in FIG. 3, the hologram recording medium 55 is produced using scattered light beams from an actual scattering plate 6 as object beams Lo. FIG. 3 shows a state in which a hologram photosensitive material 58 that has photosensitivity to become the hologram recording medium 55 is exposed by reference beams Lr and object beams Lo, both being coherent light beams that show coherence to each other.

As for the reference beams Lr, for example, laser 35 beams from a laser source that oscillates laser beams in a specific wavelength range are used. The reference beams Lr pass through a condenser element 7 made of a lens and are incident on the hologram photosensitive material 58. In the example shown in FIG. 3, laser beams to become the reference beams Lr are incident on the condenser element 7 as a parallel light flux that is parallel with the optical axis of the condenser element 7. By passing through the condenser element 7, the reference beams Lr are shaped, i.e. converted, from a parallel light flux into a convergent light flux and incident on the hologram photosensitive material 58. On this occasion, a focal point FP of the convergent light flux Lr is located at a position beyond the hologram photosensitive material 58. In other words, the hologram photosensitive material 58 is located between the condenser element 7 and the focal point FP of the convergent light flux Lr converged by the condenser element 7.

Next, the object beams Lo are incident on the hologram photosensitive material 58 as scattered light from the scattering plate 6 made of opal glass, for example. In the example shown in FIG. 3, the hologram recording medium 55 to be produced is a reflection type and the object beams Lo are incident on the hologram photosensitive material 58 on the opposite side to the reference beams Lr. It is a precondition that the object beams Lo are coherent with the reference beams Lr. Therefore, for example, it is possible to separate laser beams oscillated by the same laser source and use one of the separated ones as the reference beams Lr and the other as the object beams Lo.

In the example shown in FIG. 3, a parallel light flux that is parallel with the direction of normal to the plate surface of the scattering plate 6 is incident on the scattering plate 6 and scattered, and then the scatted beams that have passed through the scattering plate 6 are incident on the hologram photosensitive material 58 as the object beams Lo. According to this method, when an isotropic scattering plate available at usually low cost is used as the scattering plate 6, the object beams Lo from the scattering plate 6 can be incident on the hologram photosensitive material 58 at roughly constant intensity distribution. Moreover, according to this method, although depending on the degree of scattering by the scattering plate 6, the object beams Lo can be easily incident on respective positions of the hologram photosensitive material 58 at roughly constant intensity from the entire region of a light-emitting surface 6a of the scattering plate 6. In such a case, it is achievable that light beams incident on respective positions of the obtained hologram recording medium 55 reproduce images 5 of the scattering plate 6 at similar brightness and reproduced images 5 of the scattering plate 6 are observed at roughly constant brightness.

As described above, when the hologram photosensitive material 58 is exposed by the reference beams Lr and object beams Lo, interference fringes caused by the interference between the reference beams Lr and object beams Lo are generated and interference fringes of these light beams are recorded in the hologram photosensitive material 58 as some form of pattern, i.e. an refractive index modulation pattern, as one example in a volume hologram. Thereafter, an appropriate post-treatment corresponding to the type of the hologram photosensitive material 58 is applied, thereby obtaining the hologram recording medium 55.

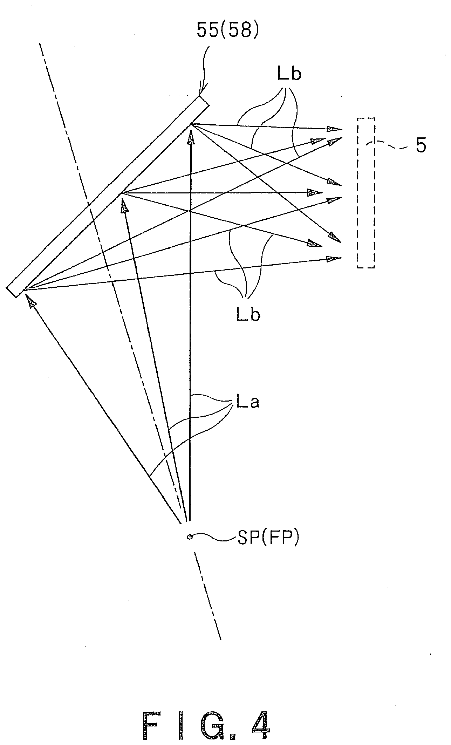

FIG. 4 is a view explaining a state in which an image of a scattering plate is reproduced using interference fringes formed in the hologram recording medium 55 obtained through an exposure process of FIG. 3. As shown in FIG. 4, the hologram recording medium 55 produced with the hologram photosensitive material 58 of FIG. 3 meets its Bragg condition by means of light beams that have the same wavelength as the laser beams used in the exposure process and travel in a reverse direction of the reference beams Lr along an optical path of the reference beams Lr in the exposure process. Namely, as shown in FIG. 4, a diverging light flux that diverges from a reference point SP located with respect to the hologram recording medium 55 so as to have the same positional relationship as the relative position of the focal point FP in FIG. 3 with respect to the hologram photosensitive material 58 in the exposure process and that has the same wavelength as the reference beams Lr in the exposure process is diffracted by the hologram recording medium 55 as the reproduction illumination light beams La, thereby creating the reproduced image 5 of the scattering plate 6 at a specific location with respect to the hologram recording medium 50 so as to have the same positional relationship as the relative position of the scattering plate 6 in FIG. 3 with respect to the hologram photosensitive material 58 in the exposure process.

In this occasion, reproduction beams Lb. i.e. beams obtained by diffracting the reproduction illumination light beams La by the hologram recording medium 55, for creating the reproduced image 5 of the scattering plate 6 reproduce respective points of the image 5 of the scattering plate 6 as beams travelling in the reverse direction of the optical path of the object beams Lo travelled towards the hologram photosensitive material 58 from the scattering plate 6 in the exposure process. As shown in FIG. 3, scattered beams Lo emitted from respective points of the light-emitting surface 6a of the scattering plate 6 in the exposure process are diffused, i.e. spread, to be incident on roughly entire region of the hologram photosensitive material 58. Namely, on respective points of the hologram photosensitive material 58, the object beams Lo from the entire region of the light-emitting surface 6a of the scattering plate 6 are incident. As a result, information of the entire light-emitting surface 6a is recorded at respective points of the hologram recording medium 55. It is therefore possible that beams which form a diverging light flux from the reference point SP and function as the reproduction illumination light beams La are incident on respective points of the hologram recording medium 55 to reproduce the images 5 of the scattering plate 5 having the same contour as one another at the same location, i.e. the illumination zone LZ, respectively.

The light beams incident on the hologram recording medium 55 are diffracted in the direction of the illumination zone LZ, hence useless scattered light can be effectively restricted. Therefore, all of the reproduction illumination beams La incident on the hologram recording medium 55 can be effectively used for creating the image of the scattering plate 6.

Next, the configuration of the irradiation unit 60 that emits coherent light beams to the optical device 50 made of the hologram recording medium 55 described above will be explained. In the example shown in FIGS. 1 and 2, the irradiation unit 60 is provided with the laser sources 61 generating coherent light beams and the scanning device 65 that changes the propagation direction of coherent light beams from the laser sources 61.

The laser source 61 emits, for example, ultraviolet light. Or a plurality of laser sources 61 that emit laser beams of different wavelength ranges may be used. When a plurality of laser sources 61 are used, it is arranged that the same point on the scanning device 65 is irradiated with a laser beam from each laser source 61. With this arrangement, the hologram recording medium 55 is illuminated with reproduction illumination light beams having illumination colors of the laser sources 61 mixed with one another.

Coherent light beams from the laser source 61 reflected by the scanning device 65 are incident on the hologram recording medium 55, thereby an image 5 of the scattering plate 6 of an illumination color in accordance with a wavelength range of the laser source 61 being created on the entire region of the illumination zone LZ.

The scanning device 65 changes the propagation direction of a coherent light beam with time to direct the coherent light beam in different directions so that the coherent light beam does not travel in the same direction. This results in that the coherent light beam, the propagation direction of which is changed by the scanning device 65, scans the incidence surface of the hologram recording medium 55 of the optical device 50.

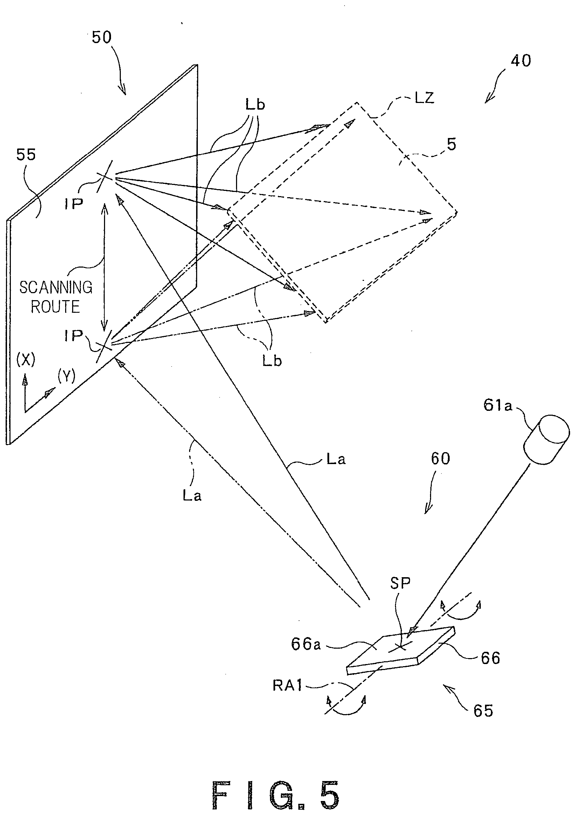

In the example shown in FIG. 2, the scanning device 65 includes a reflection device 66 having a reflection surface 66a rotatable about one axis line RA1. FIG. 5 is a view explaining a scanning route of the scanning device 65. As understood from FIG. 5, the reflection device 66 has a mirror device that has a mirror as the reflection surface 66a rotatable about one axis line RA1. The reflection device 66 is configured to change the orientation of the mirror 66a to change the propagation direction of the coherent light beams from the laser source 61. In this occasion, as shown in FIG. 2, the mirror device 66 is provided so as to receive the coherent light beams from the laser source 61 roughly at the reference point SP.

A coherent light beam, for which final adjustments were made to its propagation direction by the mirror device 66, can be incident on the hologram recording medium 55 of the optical device 50 as a reproduction illumination light beam La that can become one beam included in a diverging light flux from the reference point SP in FIG. 4. As a result, coherent light beams from the irradiation unit 60 scan the hologram recording medium 55 and coherent light beams incident on respective positions of the hologram recording medium 55 reproduce images 5 of the scattering plate 6 having the same contour on the same location, i.e. the illumination zone LZ.

As shown in FIG. 5, the reflection device 66 is configured to rotate the mirror 66a about one axis line RA1. In the example shown in FIG. 5, the rotation axis line RA1 of the mirror 66a extends in parallel with the y-axis of the x-y axis unit, that is, the x-y axis unit having the x-y plane in parallel with the surface of the hologram recording medium 55, defined on the surface of the hologram recording medium 55. Then, the mirror 66a rotates about the axis line RA1 that is in parallel with the y-axis of the x-y axis unit defined on the surface of the hologram recording medium 55. Therefore, an incidence point IP of a coherent light beam from the irradiation unit 60 on the optical device 50 moves in a reciprocating motion in the direction parallel with the x-axis of the x-y axis unit defined on the surface of the hologram recording medium 55. Namely, in the example shown in FIG. 5, the irradiation unit 60 emits a coherent light beam to the optical device 50 to scan the hologram recording medium 55 along a straight route.

The scanning device 65 including the mirror device 66 and other components is, as described above, a member rotatable about at least the axis line A1 and configured with a MEMS, for example. The scanning device 65 periodically moves in rotational motion, however, there is no particular limitation on its rotational frequency as far as it can scan the optical device 50 with coherent light beams for at least one cycle or more during one exposure time.

As a practical problem, the hologram photosensitive material 58 may shrink when the hologram recording medium 55 is produced. In such a case, it is preferable to adjust the recording angles of coherent light beams to be entered to the optical device 50 from the irradiation unit 60 under consideration of the shrinkage of the hologram photosensitive material 58. The wavelength of coherent light beams generated by the laser source 61 does not need to be precisely the same as the wavelength of the light beam used in the recording process of FIG. 3 but may be roughly the same.

In a similar reason, even if the propagation direction of a light beam to be incident on the hologram recording medium 55 of the optical device 50 does not take precisely the same route as one beam included in a diverging light flux from the reference point SP, an image 5 can be reproduced in the illumination zone LZ. Actually, in the examples shown in FIGS. 2 and 5, the mirror, i.e. reflection plane 66a of the mirror device 66 of the scanning device 65 is inevitably displaced from its rotational axis line RA1. Therefore, when the mirror 66a is rotated about the rotational axis line RA1 that does not pass through the reference point SP, a light beam to be incident on the hologram recording medium 55 may not be one of the beams that form a diverging light flux from the reference point SP. However, practically, an image 5 can be substantially reproduced in a manner that the image 5 is superimposed on the illumination zone LZ by means of coherent lights from the irradiation unit 60 having the shown configuration.

The scanning device 65 may not always necessarily reflect coherent light beams, but may refract or diffract coherent light beams, to scan the optical device 50 with the coherent light beams.

### [Effects of Basic Embodiment]

Next, the functions of the exposure apparatus having the configurations described above will be explained.

Firstly, the irradiation unit 60 emits coherent light beams to the optical device 50 so as to scan the hologram recording medium 55 of the optical device 50. Specifically, the laser source 61 generates coherent light beams having a specific wavelength that travel along a unidirection. These coherent light beams are emitted to the scanning device 65 to change their propagation directions. More specifically, the coherent light beams travel towards the hologram recording medium 55 at reflection angles in accordance with incident angles from the laser source 61, respectively.

The scanning device 65 makes coherent light beams incident on respective positions on the hologram recording medium 55 at an incident angle that meets the Bragg conditions on the respective positions. As a result, the coherent light beams incident on the respective positions reproduce images 5 of the scattering plate 6 in a manner that the images 5 are superimposed on one another on the entire region of the illumination zone LZ by diffraction caused by interference fringes recorded in the hologram recording medium 55. Namely, the coherent light beams incident on respective positions of the hologram recording medium 55 from the irradiation unit 60 are diffused, i.e. spread, by the optical device 50 to be incident on the entire region of the illumination zone LZ. In this way, the irradiation unit 60 illuminates the illumination zone LZ with coherent light beams. For example, if the laser source 61 has a plurality of laser sources 61 each emitting own color, an image 5 of the scattering plate 6 is reproduced at each color on the illumination zone LZ. Therefore, when these laser sources 61 emit light simultaneously, the illumination zone LZ is illuminated with white that is a mixture of three colors.

The position of incidence on the hologram recording medium 55 of coherent light beams from the scanning device 65 is shifted with time in each position by the operation of the scanning device 65.

In this basic embodiment, an optical image can be created on the exposure medium 15 with speckles inconspicuous, as explained below.

According to Speckle Phenomena in Optics, Joseph W. Goodman, Roberts & Co. , 2006 cited above, it is effective to integrate parameters such as polarization, phase, angle and time to increase modes. The modes here are speckle patterns with no correlation one anther. For example, when coherent light beams are projected onto the same screen in different directions from a plurality of laser sources 61, modes exist in the same number as the laser sources 61. Moreover, when coherent light beams are projected onto a screen in different directions per unit of time from the same laser source 61, modes exist by the number of changes in the incidence direction of the coherent light beams during the time that is not covered by the resolution of human eyes. It is assumed that, if there are many of this mode, the interference patterns of light are superimposed on one another and averaged with no correlation, and as a result, speckles to be observed by eyes of an observer are inconspicuous.

In the irradiation unit 60 described above, coherent light beams are emitted to the optical device 50 to scan the hologram recording medium 55. Although coherent light beams incident on respective locations of the hologram recording medium 55 from the irradiation unit 60 illuminate the entire region of the same illumination zone LZ, the illuminating direction of the coherent light beams to illuminate the illumination zone LZ are different from one another. And, since the position on the hologram recording medium 55 on which a coherent light beam is incident changes with time, the incidence direction of the coherent light beam on the illumination zone LZ also changes with time.

When considering the illumination zone LZ as the reference, a coherent light beam is always incident on each location of the illumination zone LZ, however, its incidence direction always changes. As a result, a light beam modulated by the spatial light modulator 30 is incident on the exposure medium 15 provided close to the spatial light modulator 30 that overlaps with the illumination zone LZ, while changing its optical path with time.

As described above, in this basic embodiment, a coherent light beam continuously scans the hologram recording medium 55. Following to this, the incidence direction of a coherent light beam incident on the illumination zone LZ from the irradiation unit 60 via the optical device 50 also continuously changes. When the incidence direction of a coherent light beam to the illumination zone LZ from the optical device 50 changes slightly, for example, an angle less than 1°, a speckle pattern generated on the illumination zone LZ changes greatly, resulting in superimposition of speckle patterns with no correlation. In addition, the frequency of a scanning device 65 such as a MEMS mirror and a polygonal mirror actually on the market is usually several hundred Hz or higher and a scanning device 65 of frequency reaching several ten thousands Hz is not rare.

Accordingly, according to the basic embodiment, the incidence direction of a coherent light beam changes with time on each location on the illumination zone LZ and this change occurs at a speed that is not covered by the resolution of human eyes. Therefore, if a screen is placed in the illumination zone LZ, speckle patterns generated corresponding to respective scattering patterns are superimposed on one another and averaged to be observed by an observer. Accordingly, speckles become inconspicuous effectively to an observer who observes an image displayed on the screen.

According to the reason above, in this basic embodiment, the spatial light modulator 30 is provided at the location overlapping with the illumination zone LZ. Therefore, speckles become inconspicuous at any position on the spatial light modulator 30.

Moreover, the exposure medium 15 is provided as closer to the spatial light modulator 30 as much as possible. Therefore, an optical image modulated by the spatial light modulator 30 can be guided to the surface of the exposure medium 15 as it is as much as possible.

However, if the surface of the spatial light modulator 30 is a mirror surface, coherent light beams from the hologram recording medium 55 are reflected at this mirror surface. If this reflected image is viewed by human eyes or taken by an imaging apparatus, the hologram recording medium 55 itself is viewed by an observer, hence speckles are viewed by the observer. The reason why speckles are viewed is that coherent light beams from the hologram recording medium 55 are diffused at a mirror surface, and hence a plurality of new speckles patterns cannot be generated. In other words, wavefronts from the hologram recording medium on which an identical wavefront is always generated at each point are returned and viewed by an observer as they are.

It is not so desirable that reflected light containing speckles are emitted from the spatial light modulator 30. This is because such reflected light may give a bad effect to human eyes depending on laser intensity.

In order to avoid such reflected light, as indicated by a broken line in FIG. 1, a light diffusion device 21 is provided between the hologram recording medium 55 and the spatial light modulator 30. A representative example of the light diffusion device 21 is a relief-type or volume hologram recording medium. However, there is no particular limitation to the material of the light diffusion device 21, as far as the surface is a diffusion surface. For example, glass formed into frosted glass, i.e. opaque on its one side may be used. Moreover, the light diffusion device 21 may be opal glass, a relief diffusion plate, a microlens array, etc.

With the light diffusion device 21 provided as described above, coherent light beams diffused by the light diffusion device 21 are incident on the spatial light modulator 30, and hence speckles become inconspicuous on the surfaces of the spatial light modulator 30 and the exposure medium 15, even if the surfaces are a mirror surface.

To each point on the hologram recording medium 55, a coherent light beam always having a constant wavefront is emitted. However, on each point on the light diffusion device 21, coherent light beams are incident from respective points of the hologram recording medium 55 at an angle varying with time. Therefore, the scattering characteristics are changing with time at each point of the light diffusion device 21. That is, wavefronts that are different from one another with time can be successively generated. In contrast, on the spatial light modulator 30, coherent light beams having wavefronts varying with time generated by the light diffusion device 21 are incident. Therefore, on the spatial light modulator 30, scattering patterns of coherent light beams from the light diffusion device 21 are changing with time. As a result, even if a spatial light modulator having a mirror at its part is directly observed, speckles are superimposed on one another with time, and hence speckles become inconspicuous.

Conventionally, speckles observed by humans are not only speckles at the exposure medium 15 side caused by the scattering of coherent light beams on the exposure medium 15 but also speckles at the optical device 50 side that could occur due to the scattering of coherent light beams before being projected onto the exposure medium 15. The speckle pattern generated at the optical device 50 side is also recognizable to an observer by being projected onto the exposure medium 15 via the spatial light modulator 30. However, according to the basic embodiment described above, coherent light beams continuously scan the hologram recording medium 55 and each of the coherent light beams incident on respective locations on the hologram recording medium 55 illuminates the entire region of the illumination zone LZ on which the spatial light modulator 30 is provided. Namely, the hologram recording medium 55 creates new wavefronts different from the prior wavefronts that have formed speckle patterns, thereby illuminating a screen in a complex manner and uniformly via the illumination zone LZ and further the spatial light modulator 30. By the creation of new wavefronts at the hologram recording medium 55, speckle patterns generated at the optical device 50 side become invisible.

As described above, in the basic embodiment of the present invention, the scanning device 65 makes coherent light beams scan the hologram recording medium 55, and coherent light beams emitted from the hologram recording medium 55 are incident on the spatial light modulator 30 that overlaps with the illumination zone LZ. Moreover, the exposure medium 15 is provided closer to the spatial light modulator 30. Therefore, with an extremely simple configuration, coherent light beams can be guided to the exposure medium 15, with speckles inconspicuous.

Moreover, with the light diffusion device 21 provided between the irradiation unit 60 and the spatial light modulator 30, speckles can be inconspicuous to reflected light at the spatial light modulator 30.

### [Applied Embodiment]

It is a precondition in the exposure apparatus of FIG. 1 that close exposure is performed without providing an image forming optical module between the spatial light modulator 30 and the exposure medium 15. In contrast, an applied embodiment which will be explained below has a feature in that an image forming (projection) optical module is provided.

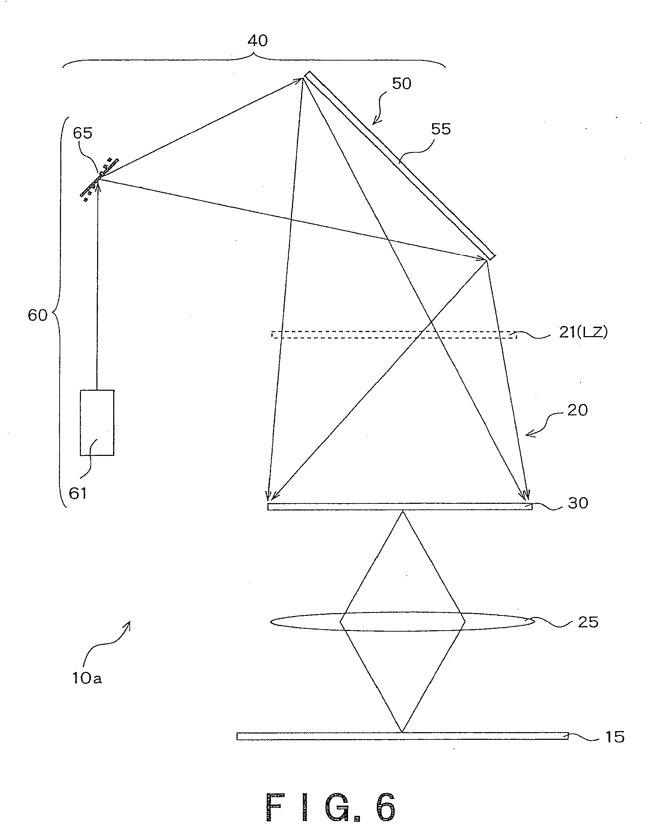

FIG. 6 is a view showing a schematic configuration of an exposure apparatus according to an applied embodiment of the present invention. In FIG. 6, the components common with FIG. 1 are denoted by the same reference numerals, and different points will be mainly explained.

An exposure apparatus 10a of FIF. 6 is provided with, like FIG. 1, the optical device 50, the irradiation unit 60, and the spatial light modulator 30, and in addition, provided with an image forming module 25 disposed between the spatial light modulator 30 and the exposure medium 15, and a light diffusion device 21 disposed between the irradiation unit 60 and the spatial light modulator 30.

The image forming module 25 is to form an image of coherent light beams modulated by the spatial light modulator 30 on the exposure medium 15. Having the image forming module 25 provided, scale-up or -down exposure is possible.

The light diffusion device 21 is essential in the exposure apparatus 10a of FIG. 6. Hereinbelow, the reason will be explained in detail.

Coherent light beams continuously scan the hologram recording medium 55. Therefore, the incident angle of coherent light beams from the irradiation unit 60 to the illumination zone LZ continuously varies and the incident angle of coherent light beams from the optical device 50 to the exposure medium 15 also continuously varies. Therefore, when the surface of the exposure medium 15 is viewed by a human at a remote place, superimposed scattering patterns of coherent light beams having no correlation are viewed by human eyes. Accordingly, speckles generated corresponding to respective scattering patterns are superimposed on one another and averaged when observed by an observer, hence the speckles being inconspicuous.

However, different from a screen, the exposure medium 15 is to record an optical image from the spatial light modulator 30. Recording an optical image on the exposure medium 15 is equivalent to recording an image viewed by human eyes when the hologram recording medium 55 is seen from the exposure medium 15. The image forming module 25 exists between the exposure medium 15 and the spatial light modulator 30. The points on the exposure medium 15 having an image formed thereon correspond to the respective points on the hologram recording medium 55 via the image forming module 25 and the spatial light modulator 30, respectively. As described above, a coherent light beam always having a constant wavefront irrespective of time is emitted. Therefore, when the hologram recording medium 55 is seen from a point on the exposure medium 15, a coherent light beam always having a constant wavefront is viewed, and since there is no factor to generate speckle patterns having no correlation, speckles being conspicuous. That is, an optical image containing speckles is undesirably recorded on the exposure medium 15.

On the contrary, when the light diffusion device 21 is provided between the hologram recording medium 55 and the spatial light modulator 30, coherent light beams are incident on each point of the light diffusion device 21 with the incident angle varying with time and light beams having scattering characteristics changing with time, that is, different wavefronts, are emitted from the light diffusion device 21. This results in that coherent light beams emitted from respective points of the light diffusion device 21 have wavefronts changing with time. Therefore, coherent light beams having wavefronts changing with time are viewed when the light diffusion device 21 side is seen from respective points on the exposure medium 15. Accordingly, speckles patterns having no correlation are superimposed on one another on the exposure medium 15, hence speckles become inconspicuous.

For the reason above, in this applied embodiment, the light diffusion device 21 is provided between the hologram recording medium 55 and the spatial light modulator 30. Ideally, it is preferable that an illumination zone for coherent light beams diffused by the optical device 50 is provided on the light diffusion device 21. With this arrangement, diffused light beams from respective points of the optical device 50 are naturally incident on the light diffusion device 21, as varying with time, hence speckles being inconspicuous when the optical device 50 side is seen from the exposure medium 15.

It does not mean that the light diffusion device 21 can be provided at any place between the irradiation unit 60 and the spatial light modulator 30. For example, if the light diffusion device 21 is provided close to the spatial light modulator 30, in more specifically, provided within the length of a depth of field of the image forming module from the spatial light modulator 30, an optical image of the light diffusion device 21 is inevitably recorded on the exposure medium 15. On the other hand, if the light diffusion device 21 is provided out of the length of the depth of field of the image forming module 25 from the spatial light modulator 30, an optical image of the light diffusion device 21 becomes completely blur, hence no possibility of forming an image on the exposure medium 15. Therefore, it is desirable that the light diffusion device 21 is provided between the irradiation unit 60 and the spatial light modulator 30 but out of the length of the depth of field of the image forming module 25 from the spatial light modulator 30.

However, when the light diffusion device 21 has a flat surface with relatively constant illuminance, such as opal glass, even if the light diffusion device 21 is provided within the length of the depth of field of the image forming module 25, an image of the light diffusion device 21 may not affect the quality of exposure to the exposure medium 15. Therefore, it is not essential to provide the light diffusion device 21 out of the length of the depth of field of the image forming module 25.

As described above, in the applied embodiment of the present invention, the scanning device 65 makes coherent light beams scan the hologram recording medium 55, and coherent light beams emitted from the hologram recording medium 55 are diffused by the light diffusion device 21. Accordingly, the interference pattern of coherent light beams emitted from respective points of the light diffusion device 21 varies. Since coherent light beams emitted from the light diffusion device 21 are incident on the spatial light modulator 30, speckles being inconspicuous on the spatial light modulator 30. Therefore, even if the image forming module 25 is provided between the spatial light modulator 30 and the exposure medium 15, speckles become inconspicuous.

### (Other features of Exposure Apparatuses 10 and 10a)

The following are common to the exposure apparatuses 10 and 10a described above, which are referred to as an "exposure apparatus according to the present embodiment", hereinbelow.

In Speckle Phenomena in Optics, Joseph W. Goodman, Roberts & Co., 2006 mentioned above, a method using a numerical value corresponding to a speckle contrast (%) as a parameter to indicate the degree of speckles generated on a screen is proposed. The speckle contrast is the quantity defined as a value obtained by dividing the standard deviation of variation in intensity actually occurred on a screen by an average value of the intensity when a test-pattern image to originally show uniform intensity distribution is displayed. A larger value of the speckle contrast means a larger degree of generation of speckles on a screen and indicates to an observer that a spotted luminance-unevenness pattern is more remarkable.

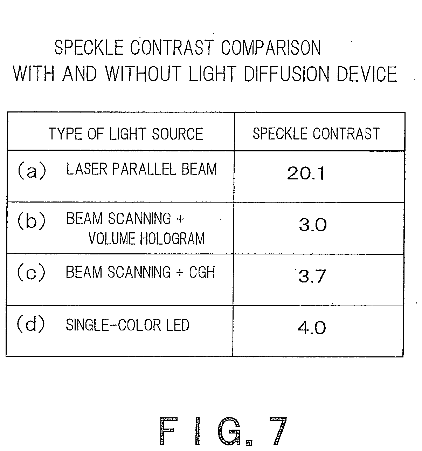

FIG. 7 is a view showing results of measuring speckle contrasts in the cases where the hologram recording medium 55 described above was used and not used. FIG. 7(a) shows a result obtained when a laser beam was directly emitted to the illumination zone LZ with no use of the scanning device 65 and the optical device 50. FIG. 7(b) shows a result obtained when a volume hologram produced having a diffusion angle of 20° was used as the optical device 50. FIG. 7(c) shows a result obtained when a relief diffusion plate was used as the optical device 50. FIG. 7(d) shows a result obtained when a singe-color LED light beam was directly emitted to the illumination zone LZ with the use of a singe-color LED, instead of the laser source 61, as the irradiation device 60.

When it is considered that a speckle contrast of 5 or lower is a reference index indicating an allowable speckle noise in a display apparatus or the like, in the present embodiment of the present invention shown in FIG. 7(b), a speckle contrast was lower than 4, and hence extremely favorable result was obtained.

The problem of generation of speckles is practically a problem unique to the case of using a coherent light source of a laser beam or the like, and thus, the problem needs not be considered in the case of an apparatus using an incoherent light source such as an LED. However, according to FIG. 7, the present embodiment is superior to the case using a singe-color LED concerning the speckle contrast. The reason may be that the light diffusion device 21 is not used for illumination for a singe-color LED. As described above, It can be said that the exposure apparatuses 10 and 10a according to the present embodiment sufficiently dealt with the speckle defect.

In addition, according to the present embodiment described above, the following advantages can be obtained.

According to the present embodiment described above, the optical device 50 for making speckles inconspicuous can also function as an optical member for reshaping and adjusting the beam shape of a coherent light beam emitted from the irradiation device 60. Therefore, it is possible to miniaturize and simplify the optical module.

Moreover, according to the present embodiment described above, coherent light beams incident on specific points in respective recording areas of the hologram recording medium 55 create images 5 of the scattering plate 6 in respective colors on the entire region of the illumination zone LZ and the spatial light modulator 30 is provided so that it is overlapped with the image 5. Therefore, it is possible to utilize all of the light beams diffracted by the hologram recording medium 55 for image creation, thus excellent in utilization efficiency of light beams from the laser sources 61.

The spatial light modulator 30 according the applied embodiment may be a transmission-type or reflection-type photomask, a micro-mirror device or a reflective-type LCOS (Liquid Crystal On Silicon).

### [Example useful in understanding the invention]

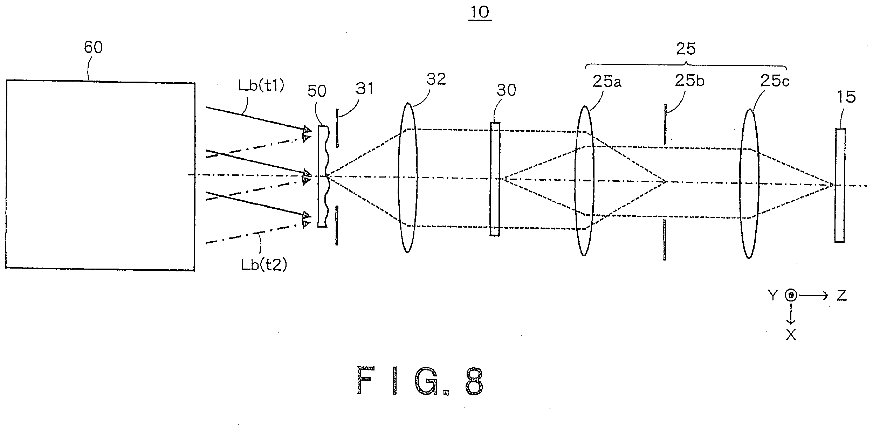

FIG. 8 is a view showing a schematic configuration of an exposure apparatus according to an example useful in understanding the present invention. An exposure apparatus 10 of FIG. 8 is provided with an irradiation unit 60, an optical device 50, a first diaphragm 31, a condensing optical module 32, a spatial light modulator 30, and an image forming module 25, for exposing an image formed on the spatial light modulator 30 on an exposure member (exposure medium) 15. It is defined in FIG. 8 that the surface of the exposure member 15 is an X-Y plain and the axis orthogonal to the surface is a Z-axis.

The irradiation unit 60 is an optical module for illuminating the optical device 50 as an illumination zone. The irradiation unit 60 illuminates the optical device 50 with illumination light beams Lb that are emitted in a direction varying with time, at a varying incident angle with respect to the effective area of the optical device 50. In this case, it is required that, by varying the direction of the illumination light beams Lb with time the illumination light beams Lb emitted at respective times are superimposed on one another with time, thereby illuminating the entire region of the effective area of the optical device 50. However, preferably, the illumination light beams Lb always illuminate the effective area of the optical device 50, that is, the entire region in the optical device 50 required for forming an image to the exposure member 15, irrespective of the emitting direction of the illumination light beams Lb. Accordingly, it is possible to give uniform brightness to an image to be formed. A variety of types of configuration can be adopted to the detailed configuration of the irradiation unit 60, which will be explained later. FIG. 8 shows illumination light beams Lb(t1) and Lb(t2) around the outermost section. Actually, the direction of the illumination light beams Lb continuously varies between Lb(t1) and Lb(t2).

The optical device 50 is an optical device for diffusing incident light. As an optical device 50 a reflection-type hologram is used. In the present example, by providing such optical device 50, coherent light beams diffused by the optical device 50 are incident on the spatial light modulator 30, thereby speckles generated at the spatial light modulator 30 and other optical components becoming inconspicuous.

The condensing optical module 32 is an optical device for converging coherent light beams emitted from the optical device 50 onto an illumination zone of the spatial light modulator 30. In the present example, light utilization efficiency is improved by converging coherent light beams emitted from the optical device 50 onto an illumination zone. With the first diaphragm 32 provided near the optical device 50 and a second diaphragm 25b provided near the image forming module 25 as a pair, the condensing optical module 32 gives uniform image-forming characteristics to all positions of the spatial light modulator 30. The first diaphragm 32 may be formed with the optical device 50 or the edge of the effective area of the optical device 50.

The spatial light modulator 30 is, for example, a transmission-type or a reflection-type reticle (photomask). In this case, an optical image corresponding to a reticle pattern is formed on the surface of the exposure member 15, thus being able to be used as an exposure apparatus for fabricating a semiconductor device. Instead of a photomask, a display device, such as a liquid crystal microdisplay, for forming an 10 image based on an input video signal may be used as the spatial light modulator 30. Also in this case, the display device may be a transmission-type or a reflection-type. The spatial light modulator 30 illuminated by the optical device 50 selects coherent light beams to pass therethrough or to be reflected per pixel, thereby forming a modulated image (optical image) of a fine pattern on the exposure member 15.

The exposure member 15 is, for example, a semiconductor wafer for forming a resist pattern. There is no particular limitation on the type of the exposure member 15. The exposure medium 15 may be a film applied with a photosensitizer.

The image forming module 25 is an optical device for forming an image created on the spatial light modulator 30 on the exposure member 15 and exposing the formed image. In the present example, the image forming module 25 includes a pair of convex lenses 25a and 25c, and the second diaphragm 25b provided therebetween. As described above, the second diaphragm 25b is used as a pair with the first diaphragm 31 provided near the optical device 50.

The irradiation unit 60 of the exposure apparatus in FIG. 8 illuminates the entire region of the effective area of the optical device 50, with the incident angle varying with time. It is preferable for realizing uniform brightness that the effective area of the optical device 50 is set to be an area that is always illuminated, irrespective of the direction of the illumination light beams Lb emitted from the irradiation unit 60.

Emitted beams from the optical device 50 illuminate spatial light modulator 30 via the condensing optical module 32. In this occasion, the condensing optical module 32 illuminates the entire region of the illumination zone of the spatial light modulator 30. Illumination light beams Lb are incident on the optical device 50 at an incident angle varying with time. Therefore, diffused light beams emitted from the optical device 50 illuminate the spatial light modulator 30 at an angle also varying with time. Accordingly, speckles generated on the illumination zone of the spatial light modulator 30 are superimposed on one another and averaged within an exposure time that is an illumination time to the exposure member 15. As a result, it is possible to restrict illumination unevenness occurred on the exposure member 15 so that an image created on the spatial light modulator 30 can be exposed on the exposure member 15 at high accuracy.

### [Avoidance of Zero-Order Light]

Part of coherent light beams from the irradiation unit 60 is not diffracted by the hologram recording medium 55 but passes though it. This type of light is called zero-order light. When zero-order light is incident on the illumination zone LZ, an abnormal region, i.e. a spotted region, a line region, and a plane region, inevitably appears in which brightness, i.e. intensity, is rapidly increased compared with the surroundings.

In the embodiments of the invention., a reflection-type hologram recording medium 55 is used. When the reflection-type hologram recording medium 55, hereinafter, "reflection-type holograms", is used, the spatial light modulator 30 and the projection optical 30 module 25 are not arranged in a propagation direction of zero-order light, hence it is relatively easy to avoid zero-order light. If a transmission-type hologram recording medium 55, hereinafter, "transmission-type holograms" would be used, it is highly likely that the spatial light 35 modulator 30 and the projection optical module 25 are arranged in a propagation direction of *zero-order* light, hence care must be taken. Specifically, it is required to design the location of the scanning device 65, the spatial light modulator 30, and the projection optical module 25 so as to be arranged in accordance with the propagation path of zero-order light so that the zero-order light does not pass through the spatial light modulator 30, the projection optical module 25, etc.

### [Reflection- and Transmission-type Hologram Recording Media]

Reflection-type holograms show higher wavelength selectivity than transmission-type holograms. In other words, in reflection-type holograms, although interference fringes corresponding to different wavelengths are superimposed on one another in layers, a coherent light beam having a desired wavelength can be diffracted by a desired layer only. In addition, reflection-type holograms are excellent in that the influence of zero-order light can be easily removed.

On the other hand, although transmission-type holograms have a wide spectrum range for diffraction and a high acceptable level to the laser source 61, if interference fringes corresponding to different wavelengths are superimposed on one another in layers, layers other than a desired layer also diffract coherent light of a desired wavelength. Therefore, in general, it is difficult to configure transmission-type holograms in a layered structure.

### (Irradiation Device 60)

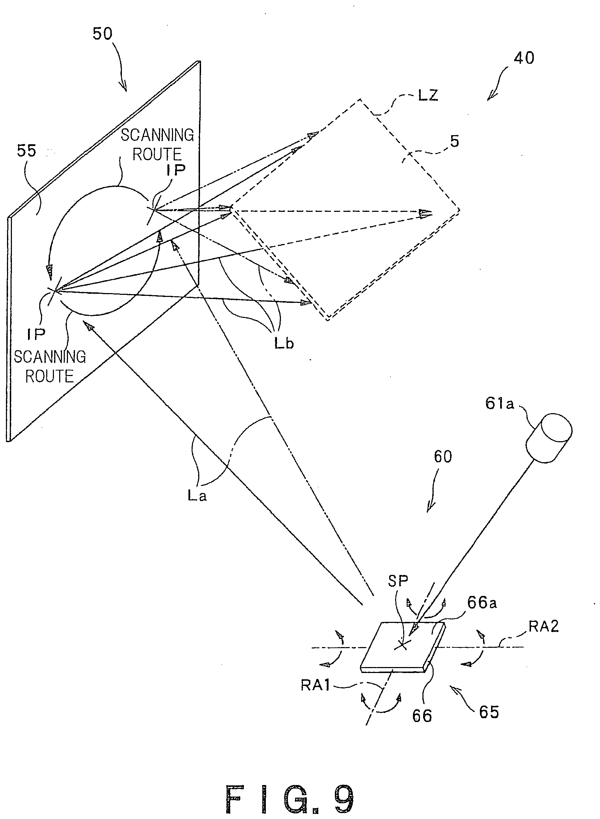

The embodiments described above show an example in which the irradiation unit 60 includes the laser sources 61 and the scanning device 65. In the example, the scanning device 65 includes the one-axis-rotation type mirror device 66 that changes the propagation direction of a coherent light beam by reflection. However, the scanning device 65 is not limited thereto. As shown in FIG. 9, the scanning device 65 may be configured so that the mirror, i.e. reflection plane 66a, of the mirror device 66 can rotate about the first rotation axis line RA1 as well as about a second rotation axis line RA2 intersecting the first rotation axis line RA1. In the example shown in FIG. 9, the second rotation axis line RA2 of the mirror 66a is perpendicular to the first rotation axis line RA1 which is extended in parallel to the Y axis of the XY coordinate unit defined on the plate plane of the hologram recording medium 55. Then, since the mirror 66a can rotate about both of the first axis line RA1 and the second axis line RA2, the incidence point IP of a coherent light beam of the irradiation unit 60 incident on the optical device 50 can be shifted on the plate plane of the hologram recording medium 55 in two-dimensional directions. Therefore, as an example, as shown in FIG. 9, the incidence point IP of a coherent light beam incident on the optical device 50 can be shifted along a circumference.

Moreover, the scanning device 65 may include two or more mirror devices 66. In this case, although the mirror 66a of the mirror device 66 can rotate about only a single axis line, the incidence point IP of a coherent light beam from the irradiation device 60 incident on the optical device 50 can be shifted on the plate plane of the hologram recording medium 55 in two-dimensional directions.

As a concrete example of the mirror device 66a included in the scanning device 65, there are a MEMS mirror, a polygonal mirror, and the like.

Moreover, the scanning device 65 may be configured to include other devices other than a reflection device, for example, the mirror device 66 described above, which changes the propagation direction of a coherent light beam by reflection. For example, the scanning device 65 may include a refraction prism, a lens, etc.

Essentially, the scanning device 65 is not a necessary component. The light source 61 of the irradiation device 60 may be configured so that it can be displaced, i.e. moved, oscillated, and rotated, with respect to the optical device 50. Coherent light beams emitted from the light source 61 may scan the hologram recording medium 55 in accordance with the displacement of the light sources 61 with respect to the optical device 50.

Moreover, although the description hereinbefore is made on condition that the light sources 61 of the irradiation device 60 oscillate a laser beam shaped into a line beam, the preset invention is not limited thereto. Particularly, in the embodiments described above, coherent light beams emitted to respective positions of the optical device 50 are shaped by the optical device 50 into a light flux which is incident on the entire region of the illumination region LZ. Therefore, no problem occurs even if coherent light beams emitted from the light sources 61 of the irradiation device 60 to the optical device 50 are not accurately shaped. For this reason, coherent light beams generated from the light sources 61 may be diverging light. In addition, the shape of coherent light beams, in cross section, generated from the light sources 61 may be an ellipse or the like instead of a circle. In addition, the transverse mode of coherent light beams generated from the light sources 61 may be a multi-mode.

In addition, when the light source 61 generates a diverging light flux, coherent light beams are incident on the hologram recording medium 55 of the optical device 50 not on a spot but on a region having a certain area. In this case, light beams which are diffracted by the hologram recording medium 55 and incident on respective positions of the illumination region LZ are angularly-multiplexed. In other words, in each instant, on respective positions of the illumination region LZ, coherent light beams are incident from directions within a certain angle range. Due to the angle-multiplexing, it is possible to more effectively make speckles inconspicuous.

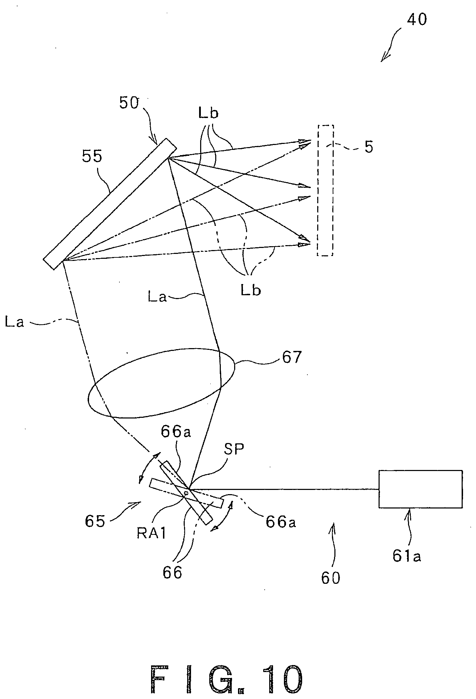

Moreover, in the embodiments described above, although the example is described in which the irradiation unit 60 emits a coherent light beam to the optical device 50 so that the coherent light beam traces the optical path of one beam included in a light flux, the present invention is not limited thereto. For example, in the above embodiments, as shown in FIG. 10, the scanning device 65 may further include a condenser lens 67 disposed at the downstream side of the mirror device 66 along the optical path of a coherent light beam. In this case, a light beam from the mirror device 66, which propagates along the optical path of light beams of a light flux, becomes a light beam that propagates in a certain direction through the condenser lens 67. In other words, the irradiation device 60 emits a coherent light beam to the optical device 50 so that the coherent light beam traces the optical path of one beam included in a light flux. In this kind of example, instead of a converging light flux described above, a parallel light flux is used as the reference light beam Lr in the recording process in the production of the hologram recording medium 55. The hologram recording medium 55 described above can be more simply produced and replicated.

### (Optical Device 50)

In the embodiments described above, although the example in which the optical device 50 is configured with a reflection-type volume hologram recording medium 55 using photopolymer has been described, the present invention is not limited thereto. Moreover, the optical device 50 may include a volume hologram recording medium that is a type in which recording is performed by using a photosensitive medium including a silver halide material. Moreover, the optical device 50 may include a relief-type, i.e. emboss-type hologram recording medium 55.

With respect to the relief-type, i.e. emboss-type, hologram recording medium, a hologram interference fringe is 30 recorded using a convex-concave structure of the surface thereof. However, in the case of the relief-type hologram recording medium, scattering due to the convex-concave structure of the surface may cause generation of new speckles, hence in this respect, the volume hologram recording medium is preferable. In the case of the volume hologram recording medium, a hologram interference fringe is recorded as a refractive index modulation pattern, i.e. refractive index distribution, of an inner portion of the medium, hence there is no influence of scattering because of the convex-concave structure of the surface.

However, even when the volume hologram recording medium is used, a type in which recording is performed using a photosensitive medium including a silver halide material may become a cause of generating new speckles due to scattering of silver halide particles. In this respect, the volume hologram recording medium using a photopolymer is preferable as the hologram recording medium 55.

Moreover, in the recording process shown in FIG. 3, although a so-called Fresnel-type hologram recording medium 55 is produced, a Fourier transform-type hologram recording medium 55 which can be obtained through recording using lenses may be produced. When the Fourier transform-type hologram recording medium 55 is used, lenses can also be used for image reproduction.

In addition, a striped pattern, i.e. refractive index modulation pattern or convex-concave pattern, which is to be formed on the hologram recording medium 55 may be designed by using a computer based on a planned wavelength or incidence direction of a reproduction illumination light beam La, a shape or position of an image to be reproduced, and the like, without use of an actual object light beam Lo and reference light beam Lr. The hologram recording medium 55 obtained in this manner is called a computer generated hologram recording medium. Moreover, when a plurality of coherent light beams having mutually different wavelength ranges are emitted from the irradiation device 60 in a similar manner in the modification described above, the hologram recording medium 55 as a computer generated hologram recording medium may be partitioned two-dimensionally into a plurality of regions provided corresponding to coherent light beams of respective wavelength ranges so that the coherent light beams of the respective wavelength ranges are diffracted in the corresponding regions to reproduce images.

Moreover, in the embodiments described above, the example is described in which the optical device 50 includes the hologram recording medium 55 by which coherent light beams emitted to respective positions thereof are spread to illuminate the entire region of the illumination region LZ. In addition to the hologram recording medium 55, the optical device 50 may include a lens array as an optical device by which the propagation directions of coherent light beams incident on respective positions thereof are changed and the coherent light beams are diffused to illumination region LZ. As a concrete example of the lens array, a total reflection-type or refraction-type Fresnel lens having a diffusing function, a fly-eye lens, and the like may be exemplified. In this type of illumination device 40, the irradiation device 60 and the optical device 50 may be configured so that the irradiation device 60 emits coherent light beams to the optical device 50 so that the coherent light beams scan the lens array and the coherent light beams incident on respective positions of the optical device 50 from the irradiation device 60 illuminate the illumination region LZ while the propagation directions of the coherent light beams are changed by the lens array, thus effectively making speckles inconspicuous.

### [Further example useful in understanding the invention]

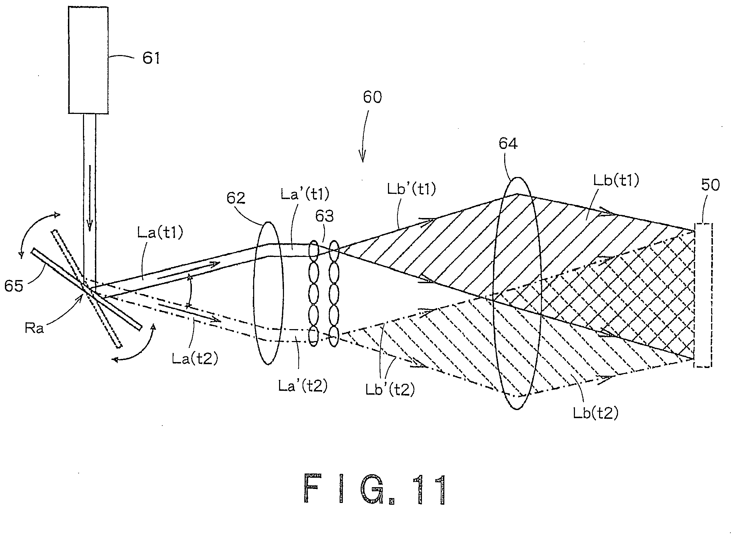

FIG. 11 is a view showing a schematic configuration of an irradiation unit 60 using a lens array according to a further example useful in understanding the invention. The irradiation unit 60 in the present example has a light source 61, a scanning device 65, a first light-path converting module 62, a lens array 63, and a second light-path converting module 64. Also in the example, an exposure apparatus can be configured by using components of the irradiation unit 60 except for the light source 61. In this case, the first light-path converting module 62 is not an essential component.

The detailed configurations of the light source 61, the scanning device 65, etc. are similar to those of the embodiments described above, hence the explanation thereof is omitted. It is preferable to provide a beam shaping means for making intensity distribution uniform in the cross section of coherent light beams emitted from the light source 61. As an design example, the beam shaping means may be provided to make intensity distribution uniform on a plane in the vicinity of the scanning device 65, with this plane and a one-dimensional light modulator plane being set as a pair to function in conjunction with each other, thereby possible to illuminate an illumination zone with constant intensity.

The scanning device 65 in the present example has a rotation center Ra in the a direction of the y-axis, to perform one-dimensional scanning of coherent light beams in the X-Z plane. Also in this case, it is required to scan the incidence plane of the lens array 63 and, as a result, sufficiently illuminate an illumination zone.

Coherent light beams incident on the scanning device 65 from the light source 61 become scanning light beams La having the direction varying with time and are incident on the lens array 63 via the first light-path converting module 62. FIG. 11 shows scanning light beams La(t1) and La(t2) in the vicinity of the outermost edge. However, practically, the scanning light beams La are shifted continuously between La(t1) and La(t2).

The first light-path converting module 62 is an optical device to change the light path of the scanning light beams La from the scanning device 65 so that the scanning light beams La are incident on the incidence plane of the lens array 63 roughly vertically. The first light-path converting module 62 is configured with a convex lens or the like having a light converging function. Scanning light beams La' for which the light path has been changed are incident on respective lens elements of the lens array 63 vertically so that the scanning light beams La' are incident on the respective lens elements under the same condition. Therefore, it is possible to reduce the burden of design such as designing the lens elements of the lens array 63 equally. The first light-path converting module 62 may not always necessarily be provided. The first light-path converting module 62 can be omitted by modifying the lens elements of the lens array 63 or the later-stage optical module in accordance with the state of incident light.

The lens array 63 is an optical device having a plurality of lens elements arranged on scanning positions (X-Y plane) of light beams by the scanning device 65, to convert a scanning light beam La' incident on each lens element to a diffused light beam. The size and shape of each lens element of the lens array 63 can be set freely according to need. For example, a cylindrical lens array having cylindrical lenses as the lens elements or a micro lens array having very small lens elements can be used.

In the present example, a plurality of stages (two stages) of lens elements are arranged in the optical-axis direction (Z-axis direction). Coherent light beams emitted from the light source 61 may not always be a parallel beam but may contain scattering components little bit deviated from a parallel state. In the present example, scattering components can be restricted by arranging a plurality of stages of lens elements in the optical-axis direction. The lens elements arranged in the optical-axis direction have an equal diameter and center axes all equally oriented in the light propagating direction. The lens array 63 may have lens elements each with one stage of lens element in the in the optical-axis direction.

The second light-path converting module 64 (a light-path converting module in the present invention) is an optical device for illuminating the optical device 50 as an illumination zone with illumination light beams Lb emitted from the lens array 63. Illumination light beams Lb emitted from respective points of the lens array 63 caused by optical scanning of the scanning device 65 illuminate the illumination zone as superimposed on one another with time via the second light-path converting module 64. It is preferable that the second light-path converting module 64 has a light converging function so that diffused light beams Lb' emitted from the lens array 63 illuminate the effective area of the optical device 50 as an illumination zone. The utilization efficiency of light beams is improved by restricting the diffusion angle of diffused light beams Lb' diffused by the lens array 63 so that the light beams are converged on the effective area of the optical device 50. Moreover, it is preferable that the second light-path converting module 64 converts the diffused light beams into a parallel beam or a roughly parallel beam. By illuminating the effective area of the optical device 50 with a parallel beam or an almost parallel beam, it is possible to illuminate respective points of the effective area under almost same condition. For example, it is possible to uniformly illuminate the entire region of the effective area.

It is sufficient for the second light-path converting module 64 to have a function of restricting the diffusion angle. The second light-path converting module 64 is configured with a combination of lenses, concave mirrors, mirrors, prisms, etc. The second light-path converting module 64 may further be configured with a hologram device, a diffraction device, etc. having the equivalent function to above or may be configured with a combination of these devices.

It is sufficient for illumination light beams Lb emitted from the second light-path converting module 64 to illuminate at least part of the effective area of the optical device 50 at each instant and illuminate the entire region of the effective area by scanning of the scanning device 65. However, it is preferable that the illumination light beams Lb illuminate the entire region of the effective area at each instant. With such configuration, it is possible to have uniform luminance distribution on the effective area of the optical device 50.

Also with the irradiation unit 60 in the present example, it is possible to illuminate the effective area of the optical device 50 with coherent light beams superimposed on one another with time, having the incident angle to each point of the effective area varying with time. As a result, diffused light beams emitted from the optical device 50 are averaged on the spatial light modulator 30 to restrict the generation of speckles which results in that irradiation unevenness of an image formed on the exposure member 15 is prevented and an image formed on the spatial light modulator 30 is accurately exposed by the exposure member 15.

### (Illuminating Method)

In the embodiments described above, an example is shown in which the irradiation device 60 is configured to be able to scan the optical device 50 in a one-dimensional direction with coherent light beams and the hologram recording medium 55 or the lens array of the optical device 50 is configured to diffuse, i.e. spread and diverge the coherent light beams incident on respective positions of the hologram recording medium 55 in a two-dimensional direction, so that the illumination device 40 illuminates the two-dimensional illumination region LZ. However, as described above, the present invention is not limited to such example. For example, the irradiation device 60 may be configured to be able to scan the optical device 50 in a two dimensional direction with coherent light beams and the hologram recording medium 55 or the lens array of the optical device 50 may be configured to diffuse, i.e. spread and diverge, the coherent light beams incident on respective positions of the hologram recording medium 55 in a two-dimensional direction, so that the illumination device 40 illuminates the two-dimensional illumination region LZ, as shown in FIG. 9.

Moreover, as already described, the irradiation device 60 may be configured to be able to scan the optical device 50 in a one-dimensional direction with coherent light beams and the hologram recording medium 55 of the optical device 50 may be configured to diffuse, i.e. spread and diverge, the coherent light beams incident on respective positions of the hologram recording medium 55 in a one-dimensional direction, so that the illumination device 40 illuminates the one-dimensional illumination region LZ. In this configuration, the scanning direction of a coherent light beam from the irradiation unit 60 and the diffusing direction, i.e. spreading direction, by the hologram recording medium 55 of the optical device 50 may be parallel with each other.

Furthermore, the irradiation device 60 may be configured to be able to scan the optical device 50 in a one- or two-dimensional direction with coherent light beams and the hologram recording medium 55 of the optical device 50 may be configured to diffuse, i.e. spread and diverge, the coherent light beams incident on respective positions of the hologram recording medium 55 in a one-dimensional direction. In this configuration, as already described, the optical device 50 may have a plurality of hologram recording media 55 to illuminate illumination zones LZ corresponding to the hologram recording media 55 successively, so that the illumination device 40 illuminates a two-dimensional region. In this occasion, the illumination zones LZ may be successively illuminated at a speed felt like as if simultaneously illuminated for human eyes or at a low speed so that human eyes can recognize that the illumination zones LZ are successively illuminated.

The present invention is not limited to the embodiments described above but includes various modifications conceivable by those skilled in the art. The effects of the present invention are also not limited to those described above. Namely, various additions, modifications and partial omissions may be applied to the disclosed embodiments without departing from the present invention defined in the accompanying claims.

## Claims

1. An exposure apparatus (10) for exposing a photosensitive medium (15), the exposure apparatus (10) comprising:
an illumination device (40), said illumination device (40) comprising:
an optical device (50) configured to diffuse coherent light beams from respective points to an entire region of at least a specific zone; and
an irradiation unit (60) configured to irradiate the coherent light beams to the optical device (50);
a spatial light modulator (30) that is provided at a location overlapped with the specific zone and illuminated by the illumination device; and
a light diffusion device (21) provided between the optical device (50) and the spatial light modulator (30), configured to diffuse coherent light beams from the optical device (50), the coherent light beams diffused by the light diffusion device (21) being incident on the spatial light modulator (30) while varying an incident angle of the coherent light beams on the optical device (50) with time,
wherein coherent light beams modulated by the spatial light modulator (30) are guidable to a surface of the photosensitive medium (15),
**characterized in that** the irradiation unit (60) is configured to make the coherent light beams scan a surface of the optical device (50) by changing propagation directions of the coherent light beams so that an incident direction of the coherent light beams incident on respective points of the spatial light modulator (30) varies with time, and
the optical device (50) is a reflection-type hologram recording medium (55) configured to reproduce an image (5) of a scattering plate (6), wherein the spatial light modulator (30) is provided so that it is overlapped with the image (5).

2. The exposure apparatus (10) of claim 1 further comprising:
an image forming optical module (25) configured to form an image of coherent light beams modulated by the spatial light modulator (30) on a surface of the photosensitive medium (15).

3. The exposure apparatus (10) of claim 2 wherein the light diffusion device (21) is provided at a location out of a length of a depth of field of the image forming module from the spatial light modulator (30).

4. The exposure apparatus (10) of claim 2 or 3 wherein the spatial light modulator (30) is a transmission-type or reflection-type photomask.

5. The exposure apparatus (10) of claim 2 wherein the spatial light modulator (30) is a micro-mirror device or a reflection-type LCOS.

6. The exposure apparatus (10) of claim 3 wherein the light diffusion device (21) is a hologram recording medium or a microlens array for reproducing an image of a reference member on a zone where respective points on a surface thereof overlap with the spatial light modulator (30).

7. The exposure apparatus (10) of claim 1 wherein the irradiation unit (60) comprises:
a light source (61) configured to emit coherent light beams; and
a scanning device (65) configured to make the coherent light beams emitted from the light source (61) scan a surface of the optical device (50) by changing propagation directions of the coherent light beams,
wherein the scanning device (65) is a mirror device capable of scanning in a one-dimensional direction so that coherent light beams scan the surface of the optical device (50).

8. The exposure apparatus (10) of claim 1 wherein the irradiation unit (60) comprises:
a light source (61) configured to emit coherent light beams; and
a scanning device (65) configured to make the coherent light beams emitted from the light source (61) scan a surface of the optical device (50) by changing propagation directions of the coherent light beams,
wherein the scanning device (65) is a mirror device capable of scanning in a two-dimensional direction so that coherent light beams scan the surface of the optical device (50).

9. The exposure apparatus (10) of claim 8 wherein the scanning device (65) has a plurality of mirror devices each corresponding to the scanning device (65) and each capable of scanning in a one-dimensional direction, to make possible scanning in the two-dimensional direction by the plurality of mirror devices.

10. Use of an exposure apparatus (10) according to any one of the preceding claims for exposing a photosensitive medium (15), wherein the spatial light modulator (30) is provided near the photosensitive medium (15).

11. Use according to claim 10, wherein the spatial light modulator (30) performs light modulation by making coherent light beams to partially pass therethrough.

## Patentansprüche

1. Eine Belichtungsvorrichtung (10) zum Belichten eines lichtempfindlichen Mediums (15), wobei die Belichtungsvorrichtung (10) Folgendes umfasst:
eine Beleuchtungsvorrichtung (40), wobei genannte die Beleuchtungsvorrichtung (40) Folgendes umfasst:
eine optische Vorrichtung (50), die konfiguriert ist, um kohärente Lichtstrahlen ausgehend von entsprechenden Punkten auf einen gesamten Bereich von mindestens einer spezifischen Zone zu streuen; und
eine Bestrahlungseinheit (60), die konfiguriert ist, um die kohärenten Lichtstrahlen auf die optische Vorrichtung (50) zu strahlen;
einen räumlichen Lichtmodulator (30), der an einem Ort bereitgestellt wird, der sich mit der spezifischen Zone überlappt und von der Beleuchtungsvorrichtung beleuchtet wird; und
eine Lichtstreuungsvorrichtung (21), die zwischen der optischen Vorrichtung (50) und dem räumlichen Lichtmodulator (30) bereitgestellt wird und so konfiguriert ist, dass sie kohärente Lichtstrahlen von der optischen Vorrichtung (50) diffundiert, wobei die von der Lichtstreuungsvorrichtung (21) diffundierten kohärenten Lichtstrahlen auf den räumlichen Lichtmodulator (30) einfallen, während ein Einfallswinkel der kohärenten Lichtstrahlen auf die optische Vorrichtung (50) zeitlich variiert wird,
wobei durch den räumlichen Lichtmodulator (30) modulierte kohärente Lichtstrahlen auf eine Oberfläche des lichtempfindlichen Mediums (15) lenkbar sind,
**dadurch gekennzeichnet, dass** die Bestrahlungseinheit (60) so konfiguriert ist, dass sie die kohärenten Lichtstrahlen eine Oberfläche der optischen Vorrichtung (50) abtasten lässt, indem sie die Ausbreitungsrichtungen der kohärenten Lichtstrahlen ändert, sodass eine Einfallsrichtung der kohärenten Lichtstrahlen, die auf jeweilige Punkte des räumlichen Lichtmodulators (30) einfallen, zeitlich variiert, und **dass**
die optische Vorrichtung (50) ein Hologramm-Aufzeichnungsmedium (55) vom Reflexionstyp ist, das so konfiguriert ist, dass es ein Bild (9) einer Streuscheibe (6) reproduziert, wobei der räumliche Lichtmodulator (30) so bereitgestellt wird, dass er sich mit dem Bild (5) überlappt.

2. Die Belichtungsvorrichtung (10) nach Anspruch 1, die ferner Folgendes umfasst:
ein optisches Bilderzeugungsmodul (25), das so konfiguriert ist, dass es ein Bild aus kohärenten Lichtstrahlen, die durch den räumlichen Lichtmodulator (30) moduliert werden, auf einer Oberfläche des lichtempfindlichen Mediums (15) erzeugt.

3. Die Belichtungsvorrichtung (10) nach Anspruch 2,
wobei die Lichtstreuungsvorrichtung (21) an einer Stelle außerhalb eines Längenbereichs einer Schärfentiefe des Bilderzeugungsmoduls vom räumlichen Lichtmodulator (30) bereitgestellt wird.

4. Die Belichtungsvorrichtung (10) nach Anspruch 2 oder 3,
wobei der räumliche Lichtmodulator (30) eine Fotomaske vom Transmissionstyp oder vom Reflexionstyp ist.

5. Die Belichtungsvorrichtung (10) nach Anspruch 2,
wobei der räumliche Lichtmodulator (30) eine Mikrospiegelvorrichtung oder ein LCOS vom Reflexionstyp ist.

6. Die Belichtungsvorrichtung (10) nach Anspruch 3,
wobei die Lichtstreuungsvorrichtung (21) ein Hologramm-Aufzeichnungsmedium oder ein Mikrolinsen-Array ist, um ein Bild eines Bezugselements in einer Zone zu reproduzieren, in der entsprechende Punkte auf einer Oberfläche davon mit dem räumlichen Lichtmodulator (30) überlappen.

7. Die Belichtungsvorrichtung (10) nach Anspruch 1, wobei die Bestrahlungseinheit (60) Folgendes umfasst:
eine Lichtquelle (61), die konfiguriert ist, um kohärente Lichtstrahlen zu emittieren; und
eine Abtastvorrichtung (65), die so konfiguriert ist, dass sie die von der Lichtquelle (61) emittierten kohärenten Lichtstrahlen eine Oberfläche der optischen Vorrichtung (50) abtasten lässt, indem sie die Ausbreitungsrichtungen der kohärenten Lichtstrahlen ändert,
wobei die Abtastvorrichtung (65) eine Spiegelvorrichtung ist, die in der Lage ist, in einer eindimensionalen Richtung abzutasten, sodass kohärente Lichtstrahlen die Oberfläche der optischen Vorrichtung (50) abtasten.

8. Die Belichtungsvorrichtung (10) nach Anspruch 1, wobei die Bestrahlungseinheit (60) Folgendes umfasst:
eine Lichtquelle (61), die konfiguriert ist, um kohärente Lichtstrahlen zu emittieren; und
eine Abtastvorrichtung (65), die so konfiguriert ist, dass sie die von der Lichtquelle (61) emittierten kohärenten Lichtstrahlen eine Oberfläche der optischen Vorrichtung (50) abtasten lässt, indem sie die Ausbreitungsrichtungen der kohärenten Lichtstrahlen ändert,
wobei die Abtastvorrichtung (65) eine Spiegelvorrichtung ist, die in einer zweidimensionalen Richtung abtasten kann, sodass kohärenten Lichtstrahlen die Oberfläche der optischen Vorrichtung (50) abtasten.

9. Die Belichtungsvorrichtung (10) nach Anspruch 8,
wobei die Abtastvorrichtung (65) eine Vielzahl von Spiegelvorrichtungen aufweist, die jeweils der Abtastvorrichtung (65) entsprechen und jeweils in einer eindimensionalen Richtung abtasten können, um ein Abtasten in der zweidimensionalen Richtung durch die Vielzahl von Spiegelvorrichtungen zu ermöglichen.

10. Verwendung einer Belichtungsvorrichtung (10) nach irgendeinem der vorstehenden Ansprüche zum Belichten eines lichtempfindlichen Mediums (15), wobei der räumliche Lichtmodulator (30) in der Nähe des lichtempfindlichen Mediums (15) bereitgestellt wird.

11. Verwendung nach Anspruch 10,
wobei der räumliche Lichtmodulator (30) eine Lichtmodulation durchführt, indem er kohärente Lichtstrahlen teilweise durch ihn hindurchtreten lässt,

## Revendications

1. Appareil d'exposition (10) pour exposer un milieu photosensible (15), l'appareil d'exposition (10) comprenant :
un dispositif d'éclairage (40), ledit dispositif d'éclairage (40) comprenant :
un dispositif optique (50) configuré pour diffuser des faisceaux de lumière cohérente à partir de points respectifs jusqu'à une région entière d'au moins une zone spécifique ; et
une unité d'irradiation (60) configurée pour irradier les faisceaux de lumière cohérente vers le dispositif optique (50) ;
un modulateur spatial de lumière (30) qui est fourni à un emplacement recouvert en partie par la zone spécifique et éclairé par le dispositif d'éclairage ; et
un dispositif de diffusion de lumière (21) fourni entre le dispositif optique (50) et le modulateur spatial de lumière (30), configuré pour diffuser des faisceaux de lumière cohérente à partir du dispositif optique (50), les faisceaux de lumière cohérente diffusés par le dispositif de diffusion de lumière (21) étant incidents sur le modulateur spatial de lumière (30) tout en faisant varier un angle d'incidence des faisceaux de lumière cohérente sur le dispositif optique (50) avec le temps,
dans lequel des faisceaux de lumière cohérente modulés par le modulateur spatial de lumière (30) sont guidables jusqu'à une surface du milieu photosensible (15),
**caractérisé en ce que** l'unité d'irradiation (60) est configurée pour amener les faisceaux de lumière cohérente à balayer une surface du dispositif optique (50) en changeant des directions de propagation des faisceaux de lumière cohérente de façon à ce qu'une direction d'incidence des faisceaux de lumière cohérente incidents sur des points respectifs du modulateur spatial de lumière (30) varie avec le temps, et
le dispositif optique (50) est un support d'enregistrement d'hologramme de type à réflexion (55) configuré pour reproduire une image (5) d'une plaque de dispersion (6), dans lequel le modulateur spatial de lumière (30) est fourni de façon à ce qu'il soit recouvert en partie par l'image (5).

2. Appareil d'exposition (10) selon la revendication 1 comprenant en outre :
un module optique de formation d'image (25) configuré pour former une image de faisceaux de lumière cohérente modulés par le modulateur spatial de lumière (30) sur une surface du milieu photosensible (15).

3. Appareil d'exposition (10) selon la revendication 2 dans lequel le dispositif de diffusion de lumière (21) est fourni à un emplacement hors d'une longueur d'une profondeur de champ du module de formation d'image à partir du modulateur spatial de lumière (30).

4. Appareil d'exposition (10) selon la revendication 2 ou 3 dans lequel le modulateur spatial de lumière (30) est un masque photographique de type à transmission ou de type à réflexion.

5. Appareil d'exposition (10) selon la revendication 2 dans lequel le modulateur spatial de lumière (30) est un dispositif à micromiroir ou un LCOS de type à réflexion.

6. Appareil d'exposition (10) selon la revendication 3 dans lequel le dispositif de diffusion de lumière (21) est un support d'enregistrement d'hologramme ou un réseau de microlentilles pour reproduire une image d'un élément de référence sur une zone où des points respectifs sur une surface de celui-ci sont recouverts en partie par le modulateur spatial de lumière (30).

7. Appareil d'exposition (10) selon la revendication 1 dans lequel l'unité d'irradiation (60) comprend :
une source de lumière (61) configurée pour émettre des faisceaux de lumière cohérente ; et
un dispositif de balayage (65) configuré pour amener les faisceaux de lumière cohérente émis à partir de la source de lumière (61) à balayer une surface du dispositif optique (50) en changeant des directions de propagation des faisceaux de lumière cohérente,
dans lequel le dispositif de balayage (65) est un dispositif à miroir capable de balayer dans une direction unidimensionnelle de façon à ce que des faisceaux de lumière cohérente balayent la surface du dispositif optique (50).

8. Appareil d'exposition (10) selon la revendication 1 dans lequel l'unité d'irradiation (60) comprend :
une source de lumière (61) configurée pour émettre des faisceaux de lumière cohérente ; et
un dispositif de balayage (65) configuré pour amener les faisceaux de lumière cohérente émis à partir de la source de lumière (61) à balayer une surface du dispositif optique (50) en changeant des directions de propagation des faisceaux de lumière cohérente,
dans lequel le dispositif de balayage (65) est un dispositif à miroir capable de balayer dans une direction bidimensionnelle de façon à ce que des faisceaux de lumière cohérente balayent la surface du dispositif optique (50).

9. Appareil d'exposition (10) selon la revendication 8 dans lequel le dispositif de balayage (65) a une pluralité de dispositifs à miroirs chacun correspondant au dispositif de balayage (65) et chacun étant capable de balayer dans une direction unidimensionnelle, pour rendre possible un balayage dans la direction bidimensionnelle par la pluralité de dispositifs à miroirs.

10. Utilisation d'un appareil d'exposition (10) selon l'une quelconque des revendications précédentes pour exposer un milieu photosensible (15), dans laquelle le modulateur spatial de lumière (30) est fourni près du milieu photosensible (15).

11. Utilisation selon la revendication 10, dans laquelle le modulateur spatial de lumière (30) réalise une modulation lumineuse en amenant des faisceaux de lumière cohérente à passer partiellement à travers celui-ci.
